# EUROPEAN PATENT APPLICATION

(11) **EP 2 375 441 A2**
(43) Date of publication of application: **12.10.2011**
(21) Application number: 11160609.1
(22) Date of filing: 31.03.2011
(51) Int. Cl.: H01L 21/673

(54) **Substrate holder, vertical heat treatment apparatus and heat treatment method**

(30) Priority: 07.04.2010 JP 2010088575
(71) Applicant: Tokyo Electron Limited, Tokyo 107-6325 (JP)
(72) Inventor: Ogino, Naotaka, Tokyo-to (JP)
(74) Representative: Liesegang, Eva

(57) **Abstract**

A substrate holder 9 includes a pair of right and left front-side support posts 26 and a pair of back-side support posts 27. The front-side support posts 26 and the back-side support posts 27 each have a plurality of grooves 28, 29 which can holed substrates W at a predetermined spacing in the vertical direction and into which the substrates W can be inserted from the front. The support surface 28a on each groove 28 of each front-side support post 26 extends obliquely forward, approaching an anteroposterior center line cl. The distance X2 between wafer support points 30, 30 at the front ends of the support surfaces 28a on opposing grooves 28 of the pair of front-side support posts 26 is equal to the distance Y2 between wafer support points 31, 31 at the front ends of the support surfaces 29a on opposing grooves 29 of the pair of back-side support posts 27.

## Description

### BACKGROUND OF THE INVENTION

### Field of the Invention:

The present invention relates to a substrate holder, a vertical heat treatment apparatus and a heat treatment method, which are suited for substrates which have such a small thickness that they will warp under their own respective weights when they are held in the substrate holder or which are warped from the beginning.

### Description of the Related Art:

In the manufacturing of a semiconductor device, a substrate, e.g. a semiconductor wafer, is subjected to various heat treatment steps, such as oxidation, diffusion, CVD, annealing, etc. Among heat treatment apparatuses for carrying out these steps is a vertical heat treatment apparatus capable of heat treating a plurality of wafers at a time.

A vertical heat treatment apparatus generally includes a heat treatment furnace having a furnace opening in the bottom, a lid for hermetically closing the furnace opening, a substrate holder (also called boat), disposed on the lid, for holding a plurality of wafers at a predetermined spacing in the vertical direction, a lifting mechanism for vertically moving the lid to carry the substrate holder into and out of the heat treatment furnace, a container (also called carrier or cassette) for housing a plurality of wafers at a predetermined spacing, and a transfer plate (also called fork) for transferring a wafer between it and the boat.

### [Patent documents]

Patent document 1: Japanese Patent Laid-Open Publication No. 2008-227443
Patent document 2: Japanese Patent Laid-Open Publication No. 2005-005379

As patterns formed in a wafer surface are becoming finer, there is a demand for the formation of thinner films on a wafer surface. Because of no need of the conventional wafer thickness for the formation of such thin films, thinner wafers are increasingly being used. There is a problem with such thinner wafers: when wafers are supported in a boat, the wafers can bend or warp under their own respective weights.

In a known process, a wafer having a conventional thickness is subjected to a film-forming step, the wafer is then thinned by grinding the back surface of the wafer, and thereafter the thinned wafer is subjected to a later film-forming step. It has been found by the present inventors that the wafer warps more when the film formed is a metal-containing film. It has also been found that the wafer warpage is not of a mortar shape but is symmetrical with respect to a center line of the wafer.

### SUMMARY OF THE INVENTION

The present invention has been made in view of the above situation. It is therefore an object of the present invention to provide a substrate holder, a vertical heat treatment apparatus and a heat treatment method, which can hold substrates in a horizontal position even when the substrates are warped, and can absorb a positional displacement of a substrate and variation in the degree of warpage of the substrate.

In order to achieve the object, the present invention provides a substrate holder having an anteroposterior center line and into which substrates can be loaded from the front, said substrate holder comprising: a pair of right and left front-side support posts each having grooves, each groove including a support surface for holding a substrate; and a pair of right and left back-side support posts each having grooves, each groove including a support surface for holding a substrate, wherein the support surfaces of the pair of front-side support posts extend obliquely with respect to the anteroposterior center line such that the front ends of the right and left support surfaces approach each other, and wherein the distance between the support surfaces of opposing grooves of the pair of front-side support posts is equal to the distance between the support surfaces of opposing grooves of the pair of back-side support posts.

The present invention also provides a vertical heat treatment apparatus comprising: a heat treatment furnace having a furnace opening in the bottom; a lid for hermetically closing the furnace opening; and a substrate holder disposed on the lid via a heat-retaining cylinder, having an anteroposterior center line and into which substrates can be loaded from the front, said substrate holder comprising: a pair of right and left front-side support posts each having grooves, each groove including a support surface for holding a substrate; and a pair of right and left back-side support posts each having grooves, each groove including a support surface for holding a substrate, wherein the support surfaces of the pair of front-side support posts extend obliquely with respect to the anteroposterior center line such that the front ends of the right and left support surfaces approach each other, and wherein the distance between the support surfaces of opposing grooves of the pair of front-side support posts is equal to the distance between the support surfaces of opposing grooves of the pair of back-side support posts.

Preferably, the substrates have such a small thickness that they will warp under their own respective weights when they are held in the substrate holder, or the substrates are warped from the beginning.

Preferably, the substrates are warped symmetrically with respect to a center line of each substrate when they are held in the substrate holder.

Preferably, the substrates are warped symmetrically with respect a center line of each substrate, and heat treatment of the substrates are carried out after aligning the warpages of the substrates by making the center lines of the substrates parallel to the direction of loading of the substrates into the substrate holder.

The present invention also provides a heat treatment method for carrying out heat treatment of substrates using a substrate holder having an anteroposterior center line and into which substrates can be loaded from the front, wherein said substrate holder comprises: a pair of right and left front-side support posts each having grooves, each groove including a support surface for holding a substrate; and a pair of right and left back-side support posts each having grooves, each groove including a support surface for holding a substrate, wherein the support surfaces of the pair of front-side support posts extend obliquely with respect to the anteroposterior center line such that the front ends of the right and left support surfaces approach each other, and wherein the distance between the support surfaces of opposing grooves of the pair of front-side support posts is equal to the distance between the support surfaces of opposing grooves of the pair of back-side support posts, the method comprising the steps of: preparing substrates each having a center line and which are warped symmetrically with respect to the center line; loading the substrates into the substrate holder in such a manner that the center lines of the substrates coincide with the center line of the substrate holder; and carrying out heat treatment of the substrates housed in the substrate holder.

In a preferred embodiment of the present invention, the heat treatment method further comprises the steps of: loading, before loading the substrates into the substrate holder, the substrate into a container in such a manner that the center lines of the substrates become parallel to the direction of loading of the substrates into the container; and loading, after carrying out the heat treatment, the substrate into a container in such a manner that the center lines of the substrates become parallel to the direction of loading of the substrates into the container.

According to the present invention, substrates to be treated can be held in a horizontal position even when the substrates are warped, a positional displacement of a substrate and variation in the degree of warpage of the substrate can be absorbed, and a substrate can be prevented from falling off the substrate holder.

### BRIEF DESCRIPTION OF THE DRAWINGS

FIG. 1 is a schematic view of a vertical heat treatment apparatus according to the present invention;
FIG. 2 is a schematic front view of a boat according to the present invention;
FIG. 3 is a cross-sectional view taken along the line X-X of FIG. 2;
FIG. 4 is a schematic side view illustrating the state of wafers supported in the boat as viewed from the direction B of FIG. 3;
FIG. 5(a) is a plan view of a fork, and FIG. 5(b) is a side view of the fork;
FIG. 6 is a schematic cross-sectional view of a boat as a comparative example;
FIG. 7 is a schematic cross-sectional view of the boat as a comparative example; and
FIG. 8 is a schematic side view illustrating the state of wafers supported in the boat as viewed from the direction B of FIG. 6.

### DETAILED DESCRIPTION OF THE PREFERRED EMBODIMENTS

Preferred embodiments of the present invention will now be described with reference to the drawings.

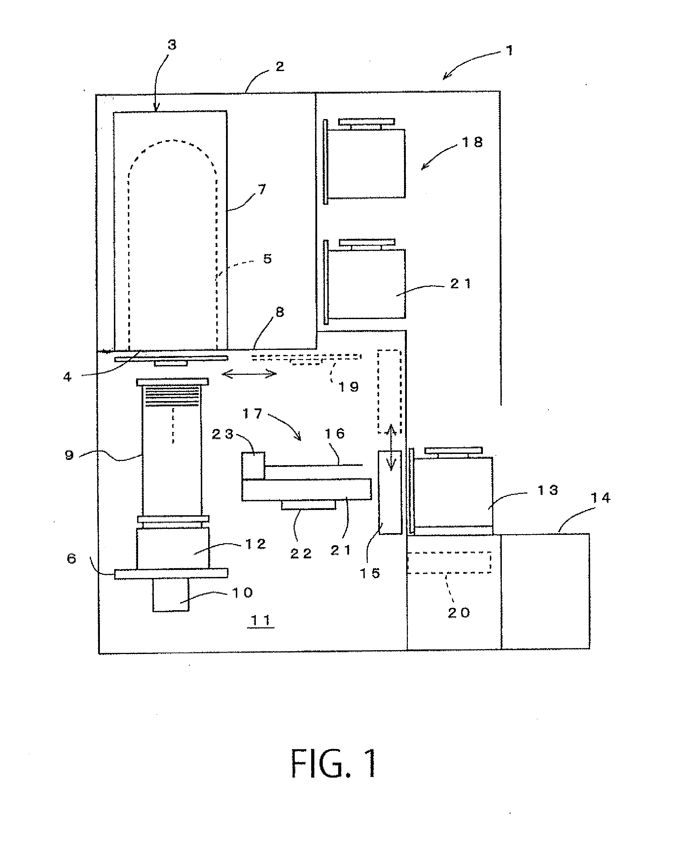

FIG. 1 schematically shows a vertical heat treatment apparatus according to the present invention. As shown in FIG. 1, the vertical heat treatment apparatus 1 includes a housing 2 that defines the outline of the apparatus. At an upper portion in the interior of the housing 2 is provided a vertical heat treatment furnace 3 for housing substrates to be treated, such as thin disk-shaped semiconductor wafers W, and carrying out a predetermined heat treatment, such as CVD. The heat treatment furnace 3 is mainly comprised of a vertically long treatment container, e.g. a quartz reaction tube 5, having a furnace opening 4 in the bottom, a vertically movable lid 6 for opening and closing the furnace opening 4 of the reaction tube 5, and a heater (heating device) 7 disposed such that it covers the circumference of the reaction tube 5. The heater 7 is capable of heating and controlling the interior of the reaction tube 5 at a predetermined temperature, e.g. 300 to 1200°C.

A base plate 8, e.g. made of stainless steel, for installation of the reaction tube 5 and the heater 7, constituting the heat treatment furnace 3, is disposed horizontally in the housing 2. The base pate 8 has a not-shown opening for insertion of the reaction tube 5 into the heater 7 from below.

The reaction tube 5, at its lower end, has an outwardly-extending flange portion which is secured to the base plate 8 by a flange holding member. The reaction tube 5, which has been inserted through the opening of the base plate 8 from below, is thus held inside the heater 7. The reaction tube 5 can be detached downward from the base plate 8 e.g. for cleaning. Though not depicted, to the reaction tube 5 are connected a plurality of gas introduction pipes for introducing a treatment gas and an inert purge gas into the reaction tube 5, and an exhaust pipe having a vacuum pump, a pressure control valve, etc. capable of controllably depressurizing the interior of the reaction tube 5. To the lower end of the reaction tube 5 may be connected a cylindrical manifold having gas introduction ports and an exhaust port, connecting with the gas introduction pipes and the exhaust pipe. In this case, the manifold serves as a furnace inlet,

Below the base plate 8 in the hosing 2 is provided a loading area (working area) 11 to perform loading of a boat (substrate holder) 9, placed on the lid 6 via a heat-retaining cylinder 12, into the heat treatment furnace 3 (i.e. the reaction tube 5), unloading of the boat 9 from the heat treatment furnace 3, and transfer of wafers W to and from the boat 9. The loading area 11 is provided with a lifting mechanism 10 for vertically moving the lid 6 to perform loading and unloading of the boat 9. The boat 9 will be described in detail later.

The lid 6 is configured to make contact with and hermetically close the furnace opening 4. The boat 9 is placed on the lid 6 via the heat-retaining cylinder 12 as a means for preventing release of heat from the furnace opening 4. The lid 6, on its upper surface, is provided with a not-shown turntable for placing thereon and rotating the heat-retaining cylinder 12 and, on its lower surface, is provided with a not-shown rotating mechanism for rotating the turntable.

In the front of the housing 2 is installed a stage (loading port) 14 for placing thereon a container 13 which can house a plurality, for example 25, of wafers at a predetermined spacing, and performing loading and unloading of the wafers into and from the housing 2. The container 13 is a hermetic container (also called FOUP) having a not-shown detachable lid at the front. In this embodiment the warpage directions of wafers in the container 13 are aligned by making a center line c1 of each wafer parallel to the direction of loading of the wafers into the container. The loading area 11 is provided with a door mechanism 15 for detaching the lid of the container 13 so as to make the interior of the container 13 open into the loading area 11. The loading area 11 is also provided with a transfer mechanism 17 including a fork (transfer plate) 16 for transferring a wafer W between the container 13 and the boat 9.

A storage shelf 18 for storing the container 13, and a not-shown transport mechanism for transporting the container 13 from the stage 14 to the storage shelf 18, and vice versa, are provided in an upper front area, lying outside the loading area 11, in the hosing 2. A shutter mechanism 19 for covering (or closing) the furnace opening 4 in order to suppress or prevent release of the heat from the furnace through the furnace opening 4 downward into the loading area 11 when the lid 6 is opened, is provided at an upper position in the loading area 11. Further, below the stage 14 is provided an alignment device (aligner) 20 for aligning in one direction cutout portions (e.g. notches) provided in the peripheries of wafers W which have been transferred by the transfer mechanism 17.

The transfer mechanism 17 includes a boxy base 21 which is vertically movable and turnable, In particular, the transfer mechanism 17 includes a lifting arm 22 which is vertically movable e.g. by means of a ball screw, and the base 21 is horizontally turnably mounted on the lifting arm 22. A movable body 23 which can move the fork 16 forward is provided on the base 21 movably back-and-forth along the horizontal longitudinal direction of the base 21. The fork 16 will be described in detail later.

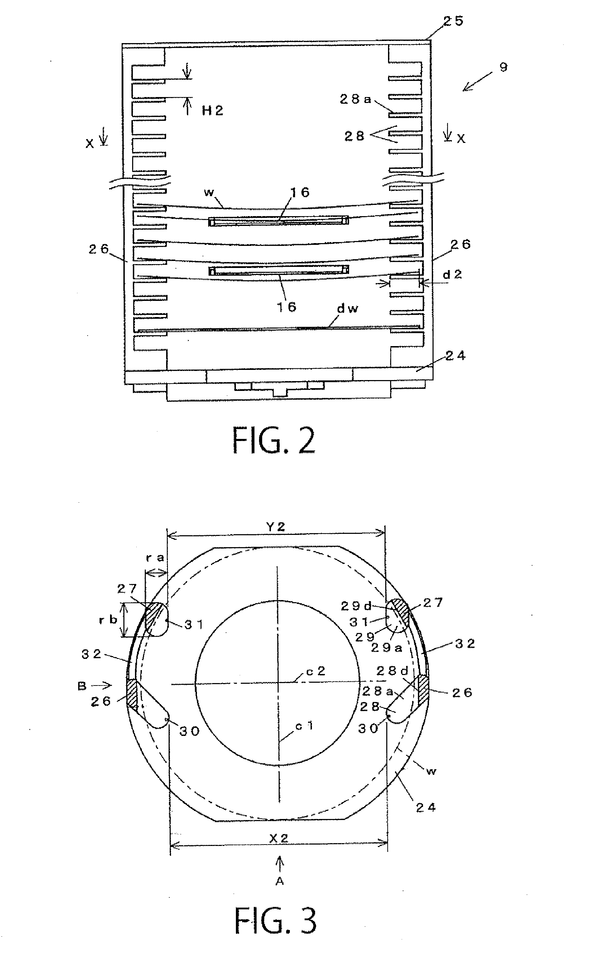

The boat 9 will now be described in detail with reference to FIGS. 2, 3 and 4. The boat 9 is, for example, made of quartz, and is capable of supporting wafers W, e.g. having a diameter of 200 mm and a thickness of 0.16 mm, in a horizontal position and in multiple stages in the vertical direction at a predetermined spacing H2, e.g. at a pitch of 12.54 mm. Each wafer W is warped symmetrically with respect to a center line of the wafer W when it is held in the boat 9. A wafer W may have such a small thickness that it warps under its own weight when it is held in the boat 9 or may be warped from the beginning. In the illustrated example, the wafers W are each thin but rigid, warped from the beginning and will not further warp under their own respective weights when they are held in the boat 9. In this case, each wafer W, when viewed from the front (in the direction of arrow A in FIG. 3), is warped upward on the right and left sides symmetrically with respect to an anteroposterior (front-back direction) center line c1, whereas the wafer W, when viewed from the side (in the direction of arrow B in FIG. 3), is not warped on the front and back sides with respect to a lateral center line c2.

The boat 9 is comprised of a disk-shaped or annular bottom plate 24, a disk-shaped or annular top plate 25, a pair of right and left front-side support posts 26 and a pair of right and left back-side support posts 27, both interposed between the bottom plate 24 and the top plate 25. The rear ends of the front-side support posts 26 are located on the lateral center line c2, and the back-side support posts 27 are located posterior to the lateral center line c2.

Each front-side support post 26 and each back-side support post 27 have a plurality of grooves 28 and 29, respectively, for supporting the peripheral portions of wafers W. The grooves 28, 29 are arranged at the predetermined pitch H2 in the vertical direction. The support surface (upper surface) 28a on each groove 28 of each front-side support post 26 extends obliquely forward, approaching the anteroposterior center line c1. The distance X2 between wafer support points 30, 30 at the front ends of the support surfaces 28a on opposing grooves 28 of the pair of front-side support posts 26 is equal to the distance Y2 between wafer support points 31, 31 at the front ends of the support surfaces 29a on opposing grooves 29 of the pair of back-side support posts 27.

In particular, each back-side support post 27 has an ellipsoidal cross section in which the anteroposterior diameter rb is larger than the lateral diameter ra. Each groove 29 of the back-side support post 27 is formed such that in a planar view, the groove bottom 29d extends in an oblique line segment. Each front-side support post 26 has an ellipsoidal cross section extending obliquely forward and inward (toward the anteroposterior center line c1) from the rear end which lies on the lateral center line c2. The front-end support post 26 has such a special shape which is quite distinct from support posts of existing boats. Each groove 28 of the front-side support post 26 is formed such that the groove bottom 28d is parallel to the anteroposterior center line c1.

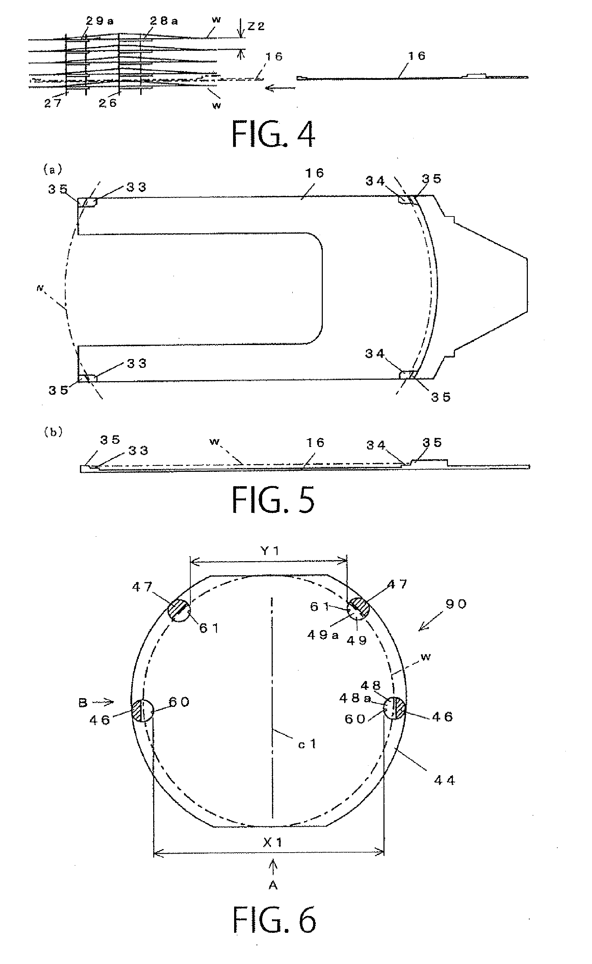

Thus, the support surface 28a on each groove 28 of each front-side support post 26 extends obliquely forward toward the center line cl. Further, the distance X2 between wafer support points 30, 30 (closest to each other) at the front ends of the support surfaces 28a on opposing grooves 28 of the pair of front-side support posts 26 is equal to the distance Y2 between wafer support points 31, 31 (closest to each other) at the front ends of the support surfaces 29a on opposing grooves 29 of the pair of back-side support posts 27. In other words, the distance X2 between the front ends of the front-side support posts 26 is equal to the distance Y2 between the inner sides of the back-side support posts 27, and the straight line (not shown) connecting the anterior and posterior support points 30, 31 on the left side of a wafer W and the straight line (not shown) connecting the anterior and posterior support points 30, 31 on the right side of the wafer W are both parallel to the wafer loading direction (direction of the anteroposterior center line cl). Therefore, even though the wafers W are warped on both sides, the wafers W, when viewed from the side, can be supported in a horizontal position and parallel to each other, and a large clearance Z2 for insertion of the fork 16 can be ensured between vertically adjacent wafers W, as shown in FIG. 4. Further, because the front ends of the front-side support posts 26 project obliquely forward toward the center line cl, a large radial dimension d2 can be ensured for the area to place a wafer W on it in the support surface 28a on each groove 28. Therefore, even when there is a positional displacement of a wafer W on grooves 28, 29 of the boat 9 or variation in the degree of warpage of the substrate W, the positional displacement and the variation in the degree of warpage can be absorbed, and disengagement of the wafer W from the grooves 28, 29 can be prevented. In FIG. 2, "dw" denotes a dummy wafer. In FIG. 3, reference numeral 32 denotes a pair of reinforcing coupling members for coupling and reinforcing the adjacent front-side and back-side support posts 26, 27 at an appropriate height position.

On the other hand, as shown in FIGS. 5(a) and 5(b), the fork 16 has a cantilever structure, horizontally extending from the base end (right side in the figures) to the front end (left side in the figures). The fork 16 has, on its upper surface, a total of four support protrusions 33, 34 for supporting the front and back sides of a wafer W in a horizontal position, and four limiting portions 35, each disposed in the vicinity of each support protrusion 33 or 34, for limiting horizontal movement of the wafer W. Contact between a wafer W and the fork 16 can be prevented by adjusting the height of the support protrusions 33, 34 according to the degree of warpage of the wafer W. While an exemplary conventional height of the support protrusions 33, 34 is 0.45 mm, the height is 1.4 mm in this embodiment.

The fork 16 is, for example, made of alumina ceramic, has a long thin plate-like shape, and is generally U-shaped, with the middle portion to the front end being bifurcated. Two front-side support protrusions 33 are provided at right and left portions of the upper surface at the front end of the fork 16, while two back-side support protrusions 34 are provided at right and left portions of the upper surface on the base end side.

According to the boat and the vertical heat treatment apparatus, having the above-described construction, the pair of right and left front-side support posts 26 and the pair of right and left back-side support posts 27 are provided, and the front-side support posts 26 and the back-side support posts 27 are provided with the grooves 28, 29 into which wafers W can be inserted from the front and which can hold the wafers W at a predetermined spacing in the vertical direction. Further, the support surface 28a on each groove 28 of each front-side support post 26 extends obliquely forward, approaching the anteroposterior center line cl. In addition, the distance X2 between the wafer support points 30, 30 at the front ends of the support surfaces 28a on opposing grooves 28 of the pair of front-side support posts 26 is made equal to the distance Y2 between the wafer support points 31, 31 at the front ends of the support surfaces 29a on opposing grooves 29 of the pair of back-side support posts 27. It therefore becomes possible to hold wafers W in a horizontal position even when the wafers W warp when they are held in the boat 9 or the wafers W are warped from the beginning, to absorb a positional displacement of a wafer and variation in the degree of warpage of the wafer, and to prevent disengagement of a wafer from the grooves 28, 29.

When wafers W are warped symmetrically with respect to their center lines cl, the warpages of the wafers W are aligned by making the center lines c1 of the wafers W parallel to the direction of loading (insertion) of the wafers W into the boat 9 before the wafers W are subjected to heat treatment. Therefore, even though the wafers W are warped, the wafers W can be held in a horizontal position, a positional displacement of a wafer and variation in the degree of warpage of the wafer can be absorbed, and a wafer can be prevented from disengaging from the grooves 28, 29 of the boat 9.

In particular, the support surface 28a on each groove 28 of each front-side support post 26 extends obliquely forward, approaching the anteroposterior center line cl, and the distance X2 between the wafer support points 30, 30 at the front ends of the support surfaces 28a on opposing grooves 28 of the pair of front-side support posts 26 is made equal to the distance Y2 between the wafer support points 31, 31 at the front ends of the support surfaces 29a on opposing grooves 29 of the pair of back-side support posts 27. Accordingly, the wafers W will not tilt (forward) in the boat 9. Thus, there is no fear of forward displacement of the wafers W due to vibration. This can ensure the fork insertion clearance Z2 between vertically adjacent wafers being equal to the groove pitch, which is 12.54 mm in this embodiment, enabling easy transport of wafers W.

Further, the radial dimension d2 of the area to place a wafer W on it in each groove 28 of the boat 9 can be made larger than the conventional one. This makes it possible to easily absorb a positional displacement of a wafer W and variation in the degree of warpage of the wafer W, and to prevent disengagement of a wafer W from the grooves 28 of the boat 9.

According to the heat treatment method of the present invention, heat treatment of wafers W, which are warped symmetrically with respect to their center lines cl, is carried out after aligning the warpages of the wafers W by making the center lines cl of the wafers W parallel to the direction of loading of the wafers W into the boat 9, using the boat 9 in which the support surface 28a on each groove 28 of each front-side support post 26 extends obliquely forward, approaching the anteroposterior center line c1, and the distance X2 between the wafer support points 30, 30 at the front ends of the support surfaces 28a on opposing grooves 28 of the pair of front-side support posts 26 is made equal to the distance Y2 between the wafer support points 31, 31 at the front ends of the support surfaces 29a on opposing grooves 29 of the pair of back-side support posts 27. Therefore, even though the wafers W are warped, the wafers W can be held in a horizontal position, a positional displacement of a wafer and variation in the degree of warpage of the wafer can be absorbed, and disengagement of a wafer from the grooves 28, 29 of the boat 9 can be prevented.

A boat or a container for use in a step prior to heat treatment is preferably configured to support wafers symmetrically with respect to the wafer loading direction. In the case of a wafer which will warp under its own weight, the warpage is symmetrical with respect to the center line cl. The directions of warpages of such wafers in a container will therefore be always constant. On the other hand, in the case of a wafer which has warped e.g. during a prior step of thinly grinding the substrate, such wafers are preferably loaded into a container after aligning the warpages (warpage directions) by making the centerline cl of each wafer parallel to the wafer loading direction. Because transport of a substrate between the container and a substrate holder is performed by means of a transfer mechanism, the direction of loading of a wafer into the substrate holder will be parallel to the wafer center line c1. Further, the wafers after heat treatment can be housed in a container, with the warpage directions of the wafers being aligned. In cases where it is difficult to automatically align the warpages of wafers, the alignment operation may be performed manually.

While the present invention has been described with reference to preferred embodiments, it is understood that the present invention is not limited to the embodiments described above, but is capable of changed and modifications within the scope of the inventive concept as expressed herein.

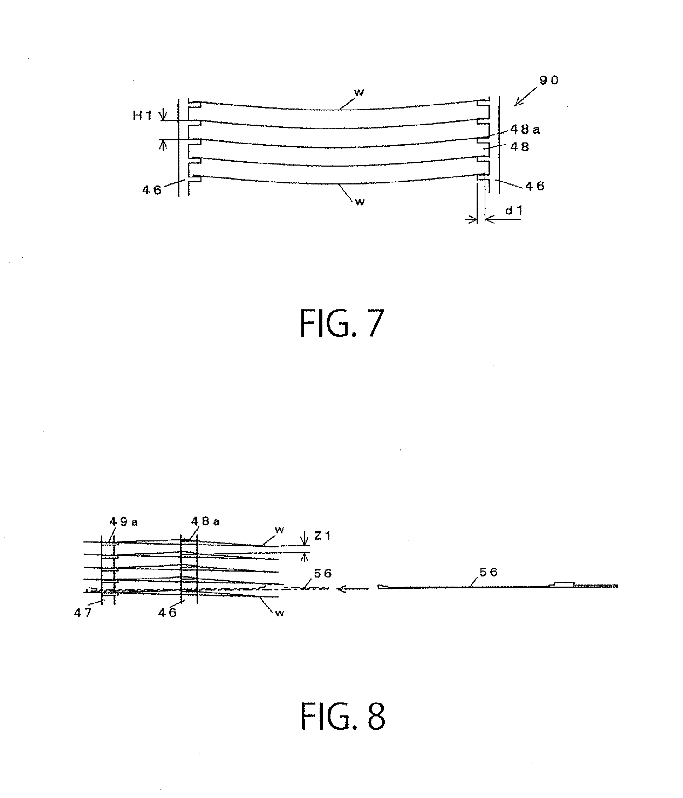

A comparative example will now be described.
As shown in FIGS. 6 and 7, a comparative boat 9 includes a pair of right and left front-side support posts 46 and a pair of right and left back-side support posts 47, both interposed between a bottom plate 44 and a top plate (not shown). The front-side support posts 46 and the back-side support posts 47 are provided with grooves 48 and 49, respectively, into which wafers W can be inserted from the front and which can hold the wafers W at a predetermined spacing in the vertical direction. Each of the front-side support posts 46 and the back-side support posts 47 has a circular cross section, and each of the grooves 48, 49 has a semicircular cross section. The peripheral portion of a wafer W is supported on the support surfaces 48a, 49a on grooves 48, 49.

The distance X1 between wafer support points 60, 60 at the front ends of the support surfaces 48a on opposing grooves 48 of the pair of front-side support posts 46 is larger than the distance Y1 between wafer support points 61, 61 at the front ends of the support surfaces 49a on opposing grooves 49 of the pair of back-side support posts 47. The distance X1 between the support points 60, 60 of the front-side support posts 46 thus differs from the distance Y1 between the support points 61, 61 of the back-side support posts 47. Further, compared to the above-described embodiment, the area of each support surface 48a of the front-side support posts 48 is small, and therefore the radial dimension dl of the area to place a wafer W on it is small.

When wafers W are held in the boat 90, the degree of warpage in the peripheral portion of a wafer W at support points 60 of the front-side support posts 46 differs from the degree of warpage in the peripheral portion of the wafer W at support points 61 of the back-side support posts 47. Accordingly, the wafers W will tilt forward when they are held in the boat 9, as shown in FIG. 8. Thus, the wafers W cannot be held in a horizontal position in a side view. Because the clearance Z1 for insertion of a fork 56 between vertically adjacent wafers is narrowed due to the tilt of the wafers W, the pitch Hl of the grooves 48, 49 of the boat 90 needs to be widened. This, however, leads to decrease in the number of wafers to be held in the boat, i.e. the number of wafers to be treated. Further, because of the small radial dimension dl of the area to place a wafer on it, the boat 90 cannot absorb a possible positional displacement of a wafer W or variation in the degree of warpage of the wafer W, and it is possible that a wafer W may disengage from grooves 48, 49 of the boat 90.
In contrast, according to the present invention, a substrate to be treated can be held in a horizontal position even when the substrate is warped, a positional displacement of a substrate and variation in the degree of warpage of the substrate can be absorbed, and a substrate can be prevented from disengaging from a substrate holder.

## Claims

1. A substrate holder having an anteroposterior center line and into which substrates can be loaded from the front, said substrate holder comprising:
a pair of right and left front-side support posts each having grooves, each groove including a support surface for holding a substrate; and
a pair of right and left back-side support posts each having grooves, each groove including a support surface for holding a substrate,
wherein the support surfaces of the pair of front-side support posts extend obliquely with respect to the anteroposterior center line such that the front ends of the right and left support surfaces approach each other, and
wherein the distance between the support surfaces of opposing grooves of the pair of front-side support posts is equal to the distance between the support surfaces of opposing grooves of the pair of back-side support posts.

2. The substrate holder according to claim 1,
wherein the substrates have such a small thickness that they will warp under their own respective weights when they are held in the substrate holder, or the substrates are warped from the beginning.

3. The substrate holder according to claim 1 or 2, wherein the substrates are warped symmetrically with respect to a center line of each substrate when they are held in the substrate holder.

4. A vertical heat treatment apparatus comprising:
a heat treatment furnace having a furnace opening in the bottom;
a lid for hermetically closing the furnace opening; and
a substrate holder disposed on the lid via a heat-retaining cylinder, having an anteroposterior center line and into which substrates can be loaded from the front,
said substrate holder comprising:
a pair of right and left front-side support posts each having grooves, each groove including a support surface for holding a substrate; and
a pair of right and left back-side support posts each having grooves, each groove including a support surface for holding a substrate,
wherein the support surfaces of the pair of front-side support posts extend obliquely with respect to the anteroposterior center line such that the front ends of the right and left support surfaces approach each other, and
wherein the distance between the support surfaces of opposing grooves of the pair of front-side support posts is equal to the distance between the support surfaces of opposing grooves of the pair of back-side support posts.

5. The vertical heat treatment apparatus according to claim 4,
wherein the substrates have such a small thickness that they will warp under their own respective weights when they are held in the substrate holder, or the substrates are warped from the beginning.

6. The vertical heat treatment apparatus according to claim 4 or 5,
wherein the substrates are warped symmetrically with respect to a center line of each substrate when they are held in the substrate holder.

7. The vertical heat treatment apparatus according to any one of claims 4 to 6,
wherein the substrates are warped symmetrically with respect a center line of each substrate, and heat treatment of the substrates are carried out after aligning the warpages of the substrates by making the center lines of the substrates parallel to the direction of loading of the substrates into the substrate holder.

8. A heat treatment method for carrying out heat treatment of substrates using a substrate holder having an anteroposterior center line and into which substrates can be loaded from the front, wherein said substrate holder comprises:
a pair of right and left front-side support posts each having grooves, each groove including a support surface for holding a substrate; and a pair of right and left back-side support posts each having grooves, each groove including a support surface for holding a substrate, wherein the support surfaces of the pair of front-side support posts extend obliquely with respect to the anteroposterior center line such that the front ends of the right and left support surfaces approach each other, and wherein the distance between the support surfaces of opposing grooves of .
the pair of front-side support posts is equal to the distance between the support surfaces of opposing grooves of the pair of back-side support posts, the method comprising the steps of:
preparing substrates each having a center line and which are warped symmetrically with respect to the center line;
loading the substrates into the substrate holder in such a manner that the center lines of the substrates coincide with the center line of the substrate holder; and
carrying out heat treatment of the substrates housed in the substrate holder.

9. The heat treatment method according to claim 8, further comprising the steps of: loading, before loading the substrates into the substrate holder, the substrate into a container in such a manner that the center lines of the substrates become parallel to the direction of loading of the substrates into the container; and
loading, after carrying out the heat treatment, the substrate into a container in such a manner that the center lines of the substrates become parallel to the direction of loading of the substrates into the container.
